# EUROPEAN PATENT SPECIFICATION

(11) **EP 4 213 059 B1**
(45) Date of publication and mention of the grant of the patent: **17.09.2025**
(21) Application number: 22305041.0
(22) Date of filing: 17.01.2022
(51) Int. Cl.: G06F 30/15, G06F 30/12, G06F 30/17

(54) **DESIGNING A PRODUCT USING PROCEDURAL GRAPHS**
ENTWURF EINES PRODUKTS UNTER VERWENDUNG VON VERFAHRENSGRAPHEN
CONCEPTION D'UN PRODUIT À L'AIDE DE GRAPHIQUES PROCÉDURAUX

(43) Date of publication of application: 19.07.2023
(73) Proprietor: Dassault Systèmes, 78140 Vélizy-Villacoublay (FR)
(72) Inventor: Goyet, Julien, Vélizy-Villacoublay (FR); Maledon, Gilles, Vélizy-Villacoublay (FR); Vergnes, Laurent, Vélizy-Villacoublay (FR); Hilliges, Andreas, Berlin (DE)
(74) Representative: Bandpay & Greuter

(56) References cited:
- EP-A1- 2 990 969
- US-A1- 2010 274 818
- US-A1- 2019 244 114

## Description

### TECHNICAL FIELD

The disclosure relates to the field of computer programs and systems, and more specifically to a method, system and program for designing a product to be manufactured.

### BACKGROUND

A number of systems and programs are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for simulating the physical behavior of a future product. CAM is an acronym for Computer-Aided Manufacturing, e.g. it relates to software solutions for defining manufacturing processes and operations. In such computer-aided design systems, the graphical user interface plays an important role as regards the efficiency of the technique. These techniques may be embedded within Product Lifecycle Management (PLM) systems. PLM refers to a business strategy that helps companies to share product data, apply common processes, and leverage corporate knowledge for the development of products from conception to the end of their life, across the concept of extended enterprise. The PLM solutions provided by Dassault Systèmes (under the trademarks CATIA, ENOVIA and DELMIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the system delivers an open object model linking products, processes, resources to enable dynamic, knowledge-based product creation and decision support that drives optimized product definition, manufacturing preparation, production and service.

Existing design solutions may be based on manipulations of procedural graphs representing products to be manufactured.

US Patent publication US2019/244114 of 8 August 2019 discloses the use of a representation of a 3D model by a graph of its sub-parts. However, there is still a need for improved design solutions in this context.

### SUMMARY

It is therefore provided a computer-implemented method for designing a product to be manufactured. The method comprises providing a first subpart and a second subpart of the product. Each subpart is represented by a semantic representation having one or more semantic nodes. Each semantic representation has, for each semantic node of the semantic representation, a respective procedural graph and a respective semantic description of the semantic node. The respective semantic description comprises at least one semantic publication. Each semantic publication points to a given node of the procedural graph of the semantic node and comprises an identifier so as to be pointed to by a semantic reference of another semantic node. Alternatively or additionally, the respective semantic description comprises at least one reference. Each semantic reference comprises a path so as to point to a semantic publication of another semantic node by referencing to the identifier of the semantic publication. Each semantic reference is pointed to by a node of the procedural graph of the semantic node. The method comprises assembling the first subpart with the second subpart by pointing one or more semantic references of the first subpart each to a respective semantic publication of the second subpart. The method comprises executing the procedural graphs of the semantic representations of the first and second subparts according to the pointed one or more semantic references.

The method may comprise one or more of the following:
- each respective semantic description of the semantic node comprises a name of the semantic node and each path comprises a reference to the name of a respective semantic node and to the identifier of a respective semantic publication;
- the assembling comprises, for each semantic reference of the one or more semantic references:
   o identifying the semantic node of the second subpart having a name that corresponds to the name referenced by the path of the semantic reference and comprising a semantic publication having an identifier corresponding to the identifier referenced by the path of the semantic reference; and
   o pointing the semantic reference of the first part to the semantic publication of the identified semantic node;
- prior to the assembling, the one or more semantic references of the first subpart each point to a respective semantic publication of a third subpart, the method further comprising, prior to the assembling, removing the pointing of the one or more semantic references each to a respective semantic publication of the third subpart;
- prior to the assembling, each semantic publication of the second subpart to which one of the one or more semantic references of the first subpart is pointed to during the assembling is pointed to by a respective semantic reference of a third subpart, the method further comprising, prior to the assembling, removing the pointing of each respective semantic reference of the third subpart each to a respective semantic publication of the second subpart;
- the method further comprises, for each subpart:
   o computing a signature of each semantic node of the semantic representation representing the subpart, the signature concatenating:
      ▪ the name of the semantic representation; and
      ▪ the identifier of each semantic publication and/or the path of each semantic reference;
- the first subpart and the second subpart are stored in a database, the database further storing one or more additional subparts, the method further comprising:
   o identifying in the database at least one subpart having a signature that matches with the signature of the provided first subpart, the identified at least one subpart including the second subpart; and
   o selecting the second subpart among the identified at least one subpart;
- during the executing, each procedural graph pointing to a semantic reference is executed after the executing of the procedural graph pointed by a semantic publication pointed by the semantic reference;
- each subpart is a component or a component of a component of a Body in White, the Body in White comprising:
   o a HAT component comprising:
      ▪ a ROOF component comprising:
         - ROOF PANEL component;
         - REAR HEADER component; or
         - FRONT HEADER component, and
      ▪ a SIDE component comprising:
         - A-PILLAR component;
         - B-PILLAR component;
         - C-PILLAR component;
         - ROOF component; or
         - ROCKER component,
   o a FRONT component; and
   o a PLATFORM component comprising:
      ▪ a FLOOR-FRONT component comprising:
         - RAIL component;
         - PANEL component;
         - SEAT CROSSMEMBER component; or
         - TUNNEL component; and
      ▪ a FLOOR-REAR component.; and/or
- the name of a semantic node is the name of the component corresponding to the semantic node.

It is further provided a computer-implemented method for obtaining a semantic representation representing a subpart. The method comprises determining one or more semantic nodes. The method comprises, for each semantic node, defining a respective procedural graph and a respective semantic description of the semantic node. The semantic description comprises at least one semantic publication. Each semantic publication points to a given node of the procedural graph of the semantic node and comprises an identifier so as to be pointed to by a semantic reference of another semantic node. Alternatively or additionally, the semantic description comprises at least one reference. Each semantic reference comprises a path so as to point to a semantic publication of another semantic node by referencing to the identifier of the semantic publication. Each semantic reference is pointed to by a node of the procedural graph of the semantic node.

It is further provided a data structure defining a subpart of a product. The data structure comprises a semantic representation having one or more semantic nodes. The data structure comprises, for each semantic node, a respective procedural graph and a respective semantic description of the semantic node. The semantic description comprises at least one semantic publication. Each semantic publication points to a given node of the procedural graph of the semantic node and comprises an identifier so as to be pointed to by a semantic reference of another semantic node. Alternatively or additionally, the semantic description comprises at least one reference. Each semantic reference comprises a path so as to point to a semantic publication of another semantic node by referencing to the identifier of the semantic publication. Each semantic reference is pointed to by a node of the procedural graph of the semantic node.

It is further provided a database comprising one or more product subparts each defined by such a data structure.

It is further provided a computer program comprising instructions for performing the method for designing a product to be manufactured and/or the method for obtaining a semantic representation representing a subpart.

It is further provided a computer readable storage medium having recorded thereon the computer program and/or the database.

It is further provided a system comprising a processor coupled to a memory, the memory having recorded thereon the computer program. Optionally, the processor may be coupled to a graphical user interface.

It is further provided a device comprising the computer readable storage medium.

The device may form or serve as a non-transitory computer-readable medium, for example on a SaaS (Software as a service) or other server, or a cloud based platform, or the like. The device may alternatively comprise a processor coupled to the data storage medium. The device may thus form a computer system in whole or in part (e.g. the device is a subsystem of the overall system). The system may further comprise a graphical user interface coupled to the processor.

### BRIEF DESCRIPTION OF THE DRAWINGS

Non-limiting examples will now be described in reference to the accompanying drawings, where:
- FIG. 1 shows an example of procedural graph representing a product;
- FIG. 2 illustrates an example of a prior art method for replacing a subpart; FIG. 3 shows an example of 3D modeled object resulting from the executing of the procedural graph of FIG. 1;
- FIG. 4 shows an example of design alternative for the product of FIG. 1;
- FIGs. 5 and 6 illustrate two examples of semantic node;
- FIG. 7 shows examples of pointing of semantic publication or reference;
- FIG. 8 shows an example of semantic representation of the product of FIG. 1;
- FIG. 9 shows an example of replacing a subpart of a product;
- FIG. 10 illustrates an example of Body in White;
- FIG. 11 shows an example of a B-PILLAR component of the Body in White of FIG. 10;
- FIG. 12 shows an example of semantic representation of the B-PILLAR component of FIG. 11;
- FIG. 13 shows an example of replacement of the FLOOR component of the Body in White of FIG. 10;
- FIG. 14 shows an example of a semantic composition.
- FIG. 15 shows an assembling of the semantic composition of FIG. 14 with two subparts;
- FIG. 16 shows a semantic composition comprising the assembling of FIG. 15;
- FIG. 17 shows an example of the GUI of the system; and
- FIG. 18 shows an example of the system.

### DETAILED DESCRIPTION

It is proposed a computer-implemented method for designing a product to be manufactured. The method comprises providing a first subpart and a second subpart of the product. Each subpart is represented by a semantic representation having one or more semantic nodes. Each semantic representation has, for each semantic node of the semantic representation, a respective procedural graph and a respective semantic description of the semantic node. The respective semantic description comprises at least one semantic publication. Each semantic publication points to a given node of the procedural graph of the semantic node and comprises an identifier so as to be pointed to by a semantic reference of another semantic node. Alternatively or additionally, the respective semantic description comprises at least one reference. Each semantic reference comprises a path so as to point to a semantic publication of another semantic node by referencing to the identifier of the semantic publication. Each semantic reference is pointed to by a node of the procedural graph of the semantic node. The method comprises assembling the first subpart with the second subpart by pointing one or more semantic references of the first subpart each to a respective semantic publication of the second subpart. The method comprises executing the procedural graphs of the semantic representations of the first and second subparts according to the pointed one or more semantic references. Such a method improves the design of the product to be manufactured.

Notably, the method improves the design of products to be manufactured by simplifying the assembling of subparts of the products. Indeed, the semantic representations of subparts simplify the design using procedural graphs and allow the designer to try alternatives of subparts in a fast, efficient, and ergonomic manner. Instead of manipulating edges of procedural graphs for trying alternatives of subparts, which may imply defining and/or modifying functions/procedures and/or rerouting edges, the method allows directly manipulating subparts of product using semantic representations of the subparts. Indeed, the semantic representation of subparts provided by the method is based on a few computer objects, *i*.*e*. the publications, semantic nodes, and references, that are configured to assembling subparts one to another. A semantic node is assembled to another semantic node by pointing a reference (or more) of the semantic node to a publication (or more) of the other semantic node. The pointing is allowed by the publication identifier, which a semantic reference may refer to. The assembling of two nodes is thereby very efficient as it relies on referencing between computer objects. The referencing may furthermore be based on strings (*e*.*g*. may use strings to reference the various nodes and features thereof), as discussed hereinafter, and thus on characters, which simplifies the assembling for a designer. Altogether, the semantic representation simplifies the assembling of subparts and avoids complex procedural graphs rerouting techniques. The semantic representation provides meaning for the designer and simplifies its design work, making the method ergonomically improved.

Moreover, the semantic representations allow simplifying the search and retrieve of subparts in databases. Indeed, the semantic nodes of the semantic representations allow the querying of subparts in the database based on their semantic representations or computer objects thereof (*e*.*g*. based on the subpart's name, which may be the corresponding semantic node's name, on subpart publication(s), and/or on subpart reference(s)). The method may notably provide subpart's signatures, as further discussed hereinafter, which are based on the semantic representation and which allow an efficient and fast query of the database. The querying may thereby be based on mechanical considerations of the subpart such as its type or the way the subpart may be assembled with another subpart, and these considerations may be captured by the various publications and references. The method therefore allows re-using design of subparts stored in database in a fast and efficient manner, thereby allowing to intelligently and efficiently reuse past designs. Additionally, the semantic representation is close to the human language and eases the understanding of the way components are linked, which makes the querying of the database ergonomic and user-friendly.

Additionally, the method allows automating the assembling (completely or a portion thereof) of subparts together which simplify the manipulations of procedural graphs. In other words, in example, the assembling step of the method may be carried out fully automatically. Indeed, the pointing of the one or more semantic references allows the method to find the connections in terms of procedure between the procedural graphs of the first and second subparts. Thus, during the executing, the pointing of the one or more semantic references allows determining in which direction and in which order the procedural graphs of each subpart are executed. The user no longer needs to enter unidirectional arcs between procedural graphs of the two subparts manually for assembling the first subpart and the second subpart. This task is automatically and efficiently performed. Moreover, the path of each semantic reference ensures that the pointing is correctly done, and thus that the execution of the procedural graphs is consistent with what is expected for the assembly of the two subparts. The method therefore allows avoiding errors of pointing occurring when the correspondence between nodes of the first and second subparts is unknown (e.g., when the nodes are listed differently in the two subparts or the two subparts have been created by a different design/engineering team).

The method thus allows the exploration of design possibilities in a fast and efficient manner and thus the testing of different assemblies during the design process. Further to the design, one or more assemblies obtained using the method may be manufactured in a manufacturing process. The method may thereby be included in a manufacturing process. The manufacturing process may comprise:
- executing the method, for example several times, *e*.*g*. in a iterative design process, thereby designing one or more assemblies of subparts and obtaining one or more 3D modeled objects representing subpart assemblies (*i*.*e*. by executing the corresponding procedural graphs according to the method). The providing of the first and second subpart may in one or more executing of the method comprise a selection of a subpart of the product being designed (*e*.*g*., the second subpart). The method may comprise selecting the subpart, e.g., based on querying a database comprising several alternatives of the second subpart;
- optionally, evaluating technical performances of the obtained designed assemblies based on the 3D modeled object(s) (e.g., using simulations);
- manufacturing the assemblies based on the modeled object(s).

The design based on semantic representations that the method allows is notably particularly adapted to the design of a body in white or of body white parts. Indeed the various components/subparts of a body in white have mechanical and assembling relations one to another that is well suited to semantic representation and that may be well captured by the semantic representation. The semantic representation thus improves body in white design, notably compared to body in white design using only procedural graphs, that may involve complex rerouting procedures.

The method is computer-implemented. This means that steps (or substantially all the steps) of the method are executed by at least one computer, or any system alike. Thus, steps of the method are performed by the computer, possibly fully automatically, or, semi-automatically. In examples, the triggering of at least some of the steps of the method may be performed through user-computer interaction. The level of user-computer interaction required may depend on the level of automatism foreseen and put in balance with the need to implement user's wishes. In examples, this level may be user-defined and/or pre-defined.

For example, the step of providing of the first subpart and the second subpart of the product may be performed upon user interaction. The providing may be done successively for each subpart. For example, the providing of the first subpart may be performed prior to the providing of the second subpart. The providing of a subpart may comprise searching, by a user, the subpart in a database by querying the database based on a semantic representation, e.g. by querying one or more semantic nodes (e.g. by inputting a query consisting of the name of the semantic node). The database may store subparts of the product including the first subpart and/or the second subpart among other subparts. The providing may further comprise retrieving from the database the one or more subparts stored in the database having a semantic representation corresponding (or matching) to the inputted the query, e.g. the retrieved subparts may comprise a node having a name corresponding the name of the query (i.e., equal or equivalent). After that, the user may select one of the subparts retrieved from the database, thereby providing the selected subpart.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

It is further provided a database comprising one or more product subparts each defined by a data structure. By "database", it is meant any collection of data (i.e. information) organized for search and retrieval (e.g. a relational database, e.g. based on a predetermined structured language, e.g. SQL). When stored on a memory, the database allows a rapid search and retrieval by a computer. Databases are indeed structured to facilitate storage, retrieval, modification, and deletion of data in conjunction with various data-processing operations. The database may consist of a file or set of files that can be broken down into records, each of which consists of one or more fields. Fields are the basic units of data storage. Users may retrieve data primarily through queries. Using keywords and sorting commands, users can rapidly search, rearrange, group, and select the field in many records to retrieve or create reports on particular aggregates of data according to the rules of the database management system being used.

The data structure comprises a semantic representation having one or more semantic nodes. The data structure comprises, for each semantic node, a respective procedural graph and a respective semantic description of the semantic node. The semantic description comprises at least one semantic publication. Each semantic publication points to a given node of the procedural graph of the semantic node and comprises an identifier so as to be pointed to by a semantic reference of another semantic node. Alternatively or additionally, the semantic description comprises at least one reference. Each semantic reference comprises a path so as to point to a semantic publication of another semantic node by referencing to the identifier of the semantic publication. Each semantic reference is pointed to by a node of the procedural graph of the semantic node.

The data structure improves the search and retrieve of subparts from the database. Indeed, the data structure allows searching and retrieving product subparts based on assembling considerations (i.e., based on whether or not they may assembled with another subpart), which increases efficiency at the design stage. Notably, the semantic description of each subpart allows determining whether or not a given subpart may be automatically assembled with another subpart using the method. The data structure is therefore suitable for searching and retrieving alternatives of subparts for an assembly.

The data structure also improves storage and allows reducing memory size for storing subparts of products. Indeed, semantic representation allows retrieving the subparts from the database efficiently, which allows to use intelligently the memory size required for storing products having similar subparts. The semantic representation allows storing each subpart only once in memory for different products instead of having to duplicate them in memory for each product. For instance, if two products comprise a same subpart, the same subpart may be stored only one for each product and may be retrieved efficiently when required based on the semantic representation of the subpart.

The executing of the procedural graphs may result in a 3D modeled object representing the assembly of the first and second subparts (e.g., described as a B-rep or a mesh). By "3D modeled object", it is meant any object which is modeled by data allowing its 3D representation. A 3D representation allows the viewing of the part from all angles. For example, a 3D modeled object, when 3D represented, may be handled and turned around any of its axes, or around any axis in the screen on which the representation is displayed. This notably excludes 2D icons, which are not 3D modeled. The display of a 3D representation facilitates design (i.e. increases the speed at which designers statistically accomplish their task). This speeds up the manufacturing process in the industry, as the design of the products is part of the manufacturing process.

The 3D modeled object may represent the geometry of the product to be manufactured in the real world subsequent to the completion of its virtual design. For example, each subpart may be a component of a Body in White, and the product may be an vehicle (or a portion thereof). A body in White refers to a stage of automobile development or manufacturing. In this stage, the sheets (without the panels and the deck) constituting the structure may have been, after stamping, assembled by welding in a ferrous chain, before the components (chassis, engine) or equipment (windows, seats, upholstery, electricity, etc.) may have been added. Body in White means the vehicle, or a portion thereof, during this manufacturing stage, for example, at an intermediate step, or at a final step. A subpart of a body in white is a component of the body in white and may thus be a component of the automotive during the manufacturing at one of these intermediate or final stages.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

"Designing a product" designates any action or series of actions which is at least part of a process of elaborating a 3D modeled object representing the product. In the case of the method, the designing may consist in selecting one or more subparts for the product, e.g. sequentially, in a database storing several alternatives for each of the one or more subparts, and assembling them. The designing may also consist in re-using subparts of already designed products in a new product (e.g., subparts stored in a database) for creating subparts assemblies. The designing may also consist in assembling subparts created from different teams of engineers (e.g., each creating one of the subparts of the product, for example one team for the first subpart and one team for the second subpart). Prior to the providing, each subpart may be created from scratch, and optionally be modified before and/or after the assembling.

As previously discussed, the method may be included in a manufacturing process, which may comprise, after performing the method, producing a physical product corresponding to the 3D modeled object provided by the executing of the procedural graphs. In any case, the provided 3D modeled object represents a manufacturing object. The 3D modeled object may thus be a modeled solid (i.e., a modeled object that represents a solid). The 3D modeled object may comprise a respective portion for each subpart (i.e., at least one for each of the first and second subparts). Because the method improves the design of the product, the method also improves the manufacturing of a product and thus increases productivity of the manufacturing process.

The semantic description is now further discussed. The semantic description of a subpart in general is discussed. This discussion thus applies to the semantic description of the first subpart, the second subpart and/or the third subpart.

The semantic description represents the subpart and has one or more semantic nodes. The semantic description may comprise information about the subpart, e.g., about the way the subpart may be assembled together with another subpart. The semantic representation may be or comprise a semantic graph formed by the one or more semantic nodes. The graph may comprise edges representing the pointings, and which may be referred to as "semantic relationships". The semantic graph may comprise one or more composition nodes each connected to a group of semantic nodes (e.g., by being connected to one or more nodes of the group) and forming an interface between the group and another group also connected to a composition node. In this case, the semantic graph may further comprise one or more edges representing relationships referred to as "delegation relationships", such edge pointing from a semantic node (or more) of the group to the composition node corresponding to the group, which means that the semantic node delegates one or more publications and/or one or more references to the composition node. Delegating means that the publication(s) and/or reference(s) of the semantic node is/are comprised by the composition node and that the semantic node comprises a referencing to said one or more publications and/or one or more references, so that the semantic node delegates its assembling with another node to the composition node. The method may store the semantic representation and/or the semantic graph in a memory.

For each semantic node, the semantic representation has a respective procedural graph. The procedural graph may comprises nodes and edges (e.g., unidirectional or bidirectional arcs) between these nodes. Each node of the procedural graph represents a geometrical object (e.g. a point, a line, a profile or any 3D object such as a sphere). Each unidirectional arc may be associated with a function taking as input the geometrical object represented by the node pointed by the unidirectional arc and outputting the geometrical object represented by the node from which the unidirectional arc points. Examples of functions include extrusion, revolution or inclusion of features (such as fillets, chamfers or shells). A function may also be associated with two or more unidirectional arcs and in that case, the function may take as input the geometrical object of the nodes pointed by the two or more unidirectional arcs. Examples of functions associated with more than one unidirectional arc include projection or addition of constraints between the geometrical objects of the nodes. The procedural graph of each semantic node may comprise functions which, when executed (e.g., sequentially), may construct a modeled object representing the semantic node. Nodes of the procedural graph may represent the 3D modeled object representing the semantic node at intermediate stages of this construction.

For each semantic node, the semantic representation has a respective semantic description of the semantic node. The semantic description comprises computer data, *i*.*e*., publications and/or references, describing/capturing how the semantic node may connect with other semantic nodes (*e*.*g*., semantic nodes of the semantic representation representing another subpart). The semantic description comprises at least one semantic publication and/or at least one semantic reference. This means that a semantic description may comprise only at least one semantic publication (i.e. one or more, e.g., one, two or any integer n larger than two semantic publications), only at least one semantic reference (*i*.*e*. one or more, e.g., one, two or any integer n larger than two semantic references) or a combination of at least one (*i*.*e*. one or more) semantic publication and at least one semantic (*i*.*e*. one or more) reference.

A semantic publication of a semantic node is a computer object associated with the semantic node and which points to a given node of the respective procedural graph for this semantic node. Each semantic publication points to a given node of this procedural graph (e.g., the semantic publications may each point to a different node, or there may be only one publication pointing to only one node of the procedural graph). Pointing is the action of linking a first computer object to a second computer object so that the second computer object is read when the first computer object is read. Hence, when the given node is read (e.g., during the executing), the semantic publication is then read. The same applies equally for the pointing of a semantic reference to a semantic publication (i.e., when the semantic publication is read, then the semantic reference pointing to the semantic publication is read), or the pointing of a node of the procedural graph to a semantic reference (when the reference is read, the node pointing to the reference is read).

The pointing of the semantic publication to the given node may be provided by any means. For example, each node of the procedural graph may comprise a unique identifier (i.e., that differs from the identifier of each other node in the procedural graph), and the semantic publication may comprise the identifier of the node to which it points such that the method may read, based on the unique identifier, the publication after the node of the procedural graph. The method may store the pointing from each semantic publication to a given node of the procedural graph in the memory (e.g., together with the semantic representation or the semantic node).

Each semantic publication comprises an identifier so as to be pointed to by a semantic reference of another semantic node. This means that a semantic publication may be pointed by a semantic reference of another semantic node, thereby allowing assembly of the two semantic nodes by pointing the reference to the publication. Prior to the assembly, a semantic publication may be not pointed by the semantic reference, and after the assembly, the semantic publication may be pointed. Hence, prior to the assembling, the semantic representation of the second subpart may comprise one or more semantic publications not pointed to by a semantic reference, and the one or more semantic publications may be pointed to by the one or more semantic references during the assembling. Each semantic publication may be pointed by only one semantic reference and each semantic reference may point to only one semantic publication.

The identifier of a semantic publication comprises data distinguishing the publication from other publications in the semantic node comprising the semantic publication. When the semantic node comprises more than one publication, the identifier may be unique with respect to all other publications of the semantic node. The identifier may comprise a list (ordered or non-ordered) of elements, such as a list of numbers or a string. In examples, the name may be the name of a portion of the object which corresponds to the semantic node.

A semantic reference of a semantic node is a computer object associated with the semantic node and which allows the pointing to a semantic publication. Each semantic reference comprises a path so as to point to a semantic publication of another semantic node by referencing to the identifier of the semantic publication. This means that a semantic reference may point to a semantic publication of another node, thereby allowing assembly of the two semantic nodes by pointing the reference to the publication. Prior to the assembly, a semantic reference may not point to the semantic publication, and after the assembly, the semantic reference may point to the semantic publication. Hence, prior to the assembling, the semantic representation of the first subpart may comprise one or more semantic references not pointing to a semantic publication, and these one or more semantic references may be the pointed one or more semantic during the assembling. Each semantic reference may point to only one semantic publication.

The path comprises data distinguishing the semantic publication in the semantic representation of the another subpart (i.e., among each other semantic publication of the semantic representation of the another subpart). The path may be the path to the semantic publication in the semantic graph of the semantic representation.

Each semantic reference is pointed to by a node of the procedural graph of the semantic node. For example, each semantic reference of a semantic node may comprise a unique identifier (i.e., that differs from the identifier of each other semantic reference of the semantic node), and the node pointing to the semantic reference may comprise the identifier of the semantic reference. Thereby, the method may read, based on the unique identifier, the node of the procedural graph after the semantic reference. The method may store the pointing from a given node of the procedural graph to each semantic reference in the memory (e.g., together with the semantic representation or the semantic node). Alternatively, the semantic reference may comprise the identifier of the node pointing to the semantic reference, and the method may comprise automatically determining, based on the identifier of the node, the semantic reference pointed by the node among other semantic references of the semantic node.

In examples, each respective semantic description of the semantic node may comprise a name of the semantic node (e.g., the name may be a string). The name of the semantic node may describe (*i*.*e*. correspond to the real-world name of the) the subpart when the semantic representation comprises only one node or may describe (*i*.*e*. correspond to the real-world name of the) a portion of the subpart corresponding to the node. The portion of the subpart may be a portion configured to be assembled with another subpart, *e*.*g*. with a portion of this another subpart, such as an end of the subpart or a connection point.

In examples, each path may comprise a reference to the name of a respective semantic node and the identifier of a respective semantic publication. The name referenced by the path may correspond to the name of a semantic node of another subpart (*e*.*g*. a component thereof). The semantic node may comprise a semantic publication having an identifier corresponding to the identifier referenced by the path. In examples, the name and the identifier may be comprised by the path. In other words, the reference to the name and the identifier may comprise the identifier and the name. For example, the name and the identifier may be concatenated (*e*.*g*. as a string) in the data of the path (e.g., using for the convention "name/identifier", wherein "name" is the name of the semantic node of the another subpart and "identifier" is the identifier of the semantic publication). In other examples, the reference to the name and the identifier may comprise a path to a semantic composition comprising the name and the identifier. In that case, the path may use the convention "./identifier", wherein "identifier" is the identifier of the semantic publication of the semantic composition and "." is the path to the semantic composition comprising the semantic node. In other words, the name and the identifier may be referenced via the semantic composition.

In examples, a semantic representation may comprise one or more semantic compositions. A semantic composition is a node that represents a set of semantic nodes (e.g., when the set of nodes may form a subpart and/or a component of the subpart). A semantic composition interfaces with other semantic compositions via the semantics nodes they comprise. In order to interface, one or more semantic nodes of the set may delegate semantic references and/or semantic publications to the semantic composition, which allows assembly with another semantic node of another semantic composition. The delegation of the semantic references and/or semantic publications replaces the direct pointing between two semantic nodes of two semantic compositions that may exist in other examples. The delegation is an alternative to the direct pointing. In that case, the path of the semantic reference may be the path to the semantic composition and may comprise the identifier of the semantic reference delegated for the semantic reference. The semantic compositions improve the design of product, because a product is generally composed of assembled parts, each of which generally corresponds in turn to an assembly of subparts. Using semantic compositions therefore allows representing this assembly of parts and subparts, which improves the design of the product.

The assembling of the first subpart with the second subpart is now further discussed.

The assembling of the first subpart with the second subpart comprises the pointing of the one or more semantic references of the first subpart each to a respective semantic publication of the second subpart. The assembling may consist in reading the paths and identifiers (either automatically or by user action) and making the possible connections according to this reading (either automatically or by user action, *e.g.* by graphical user interactions, *e.g.* by using a drag and drop or a keyboard action to create an edge linking a reference to a publication), thereby result in a pointing between procedural nodes in fine.

In examples, the assembling may be performed automatically. For example, the assembling may comprise, for each semantic reference of the one or more semantic references, determining the semantic publication of the second subpart pointed by the semantic reference based on the path (e.g., sequentially or in parallel). Each of the one or more semantic references may be pointed to a different semantic publication of the second subpart. In other examples, the pointing of the one or more semantic reference may be performed semi-automatically. For example, the method may comprise, for each semantic reference, automatically determining the semantic publication of the second subpart pointed by the semantic reference, and, upon user interaction, confirming the pointing of the semantic reference to the determined publication.

The pointing of a semantic reference to a semantic publication is now further discussed.

The pointing of a semantic reference to a semantic publication may comprising pointing the node pointing the semantic reference and the node pointed by the semantic publication. The pointing of the node pointing the semantic reference and the node pointed by the semantic publication may comprise assembling a first pointing (from a first node of a procedural graph of the first subpart to the semantic reference of the first subpart), a second pointing (from the semantic reference to the semantic publication of the second subpart) and a third pointing (from the semantic publication to a second node of a procedural graph of the second subpart), thereby forming a single pointing from the first node of the first subpart to the second node of the second subpart.

The executing of the procedural graphs of the semantic representations of the first and second subparts is now further discussed.

In a procedural graph, a unidirectional arc represents a procedural relationship between two nodes. "Unidirectional" means that the arc points (or is directed) from a first one of the two nodes to the second one of the two nodes. Each unidirectional arc is associated with a function, which may solely be associated with the unidirectional arc or may be associated with other unidirectional arcs (i.e., each function is associated with one or more procedural relationships). The procedural graph may also comprise, although not shown in any example herein, bidirectional arcs which may be referred to as "live relationships" or "constraints, and which represent constraints between the two geometric objects represented by the two nodes connected by each bidirectional arc.

The executing of the procedural graphs may comprise an execution of each function (e.g., sequentially) of the procedural graphs of the first and second subparts. The executing of a function may comprise taking as input the one or more geometric objects of the one or more nodes pointed by the one or more procedural relationships associated with the function, applying the function to the one or more geometric objects and outputting the result of the application of the function to the one or more geometrical objects. The result of the application of the function to the one or more geometrical objects is the geometrical object represented by the node from which each of the one or more procedural relations associated with the function points. It is to be understood that the direction of the pointing is only one example of a convention, and that in other examples using other conventions, the pointing of unidirectional arcs may be different (e.g., a node pointed by an unidirectional arc may represent the output of the function, and a node from which a unidirectional arc points may be an input of the function). In these other conventions, the same convention for the pointing may apply to the pointing from a node to a semantic reference, the pointing from a semantic reference to a semantic publication and the pointing from a semantic publication to a node may also be inversed (*i*.*e*. although the pointing is, informatically, still the same, its representation by an arrow/edge uses the inverse convention that the input of the edge is its beginning node and that the output of the edge is the node to which the edge points).

The executing of the procedural graphs is according to the pointed one or more semantic references (i.e., the pointing resulting from the assembling). The executing may comprising first traversing and executing a procedural graph of one or the semantic nodes (or traversing and executing several procedural graphs of several semantic nodes in parallel). The one or several procedural graphs traversed and executed first are each pointed to by a semantic publication. The executing may comprise executing functions according to the directions of the unidirectional arcs. At some point of the traversal, the traversal leads to a first node that is pointed to by a semantic publication, and the executing may comprise reading the path of the semantic publication thereby executing the semantic publication, and then, the read of the semantic reference that points to the semantic publication and that is pointed to by a second node of another procedural graph (i.e., the said another procedural graph points to the semantic reference). Hence, from a computing point of view, reading the paths leads to connect the first node and the second node, and thus to say that the second node is a function of the first node (the function may be referred to as an adjacency contact relation). In the case of a semantic composition, this executing of the paths may pass through the semantic composition using the delegation relationships.

Hence, the executing of the procedural graphs may comprise executing each function of the procedural graphs of the first subpart and second subpart including said adjacency contact relations between nodes belonging to the first subpart and those belonging to the second subpart.

An adjacency contact relation defined between nodes of the first and the second subparts may represent an assembly of the first with the second subparts (e.g., a nesting or a welding of parts). Indeed, a adjacency contact relation takes as input a geometrical object representing the second subpart (or a portion thereof) and output a geometrical object representing an assembly of the first subpart and the second subpart. For example, the first subpart may be a bar and the second subpart a board, and the outputted geometrical object may represent a projection of the bar on the board. The adjacency contact relations defined between nodes of the first and the second subparts therefore represent the mechanical assembly of the first subpart with the second subpart.

In examples, during the executing, each procedural graph pointing to a semantic reference may be executed after the executing of the procedural graph pointed by a semantic publication pointed by the semantic reference. For example, the executing may comprise, for each of the pointed one or more semantic references, executing the procedural graph comprising the node pointed by the semantic publication pointed by the semantic reference. The executing of a procedural graph may comprise executing each function of the procedural graph (i.e., function taking as input and outputting geometrical objects represented each by a node in the procedural graph). Then, the executing may comprise, based on the pointing of the reference to the publication and of a node to the reference, executing the adjacency contact relation defined between nodes of the first and the second subparts. The executing may comprise executing the procedural graph comprising the node pointing to the semantic reference.

In examples, the assembling may comprise, for each semantic reference of the one or more semantic references, identifying the semantic publication pointed by the semantic reference. The identifying of the semantic publication may comprise determining the semantic node of the second subpart having a name that corresponds to the name referenced by the path of the semantic reference. Correspond means that the names may be equal or equivalent (e.g., synonymous). Then, the identifying may comprise identifying the semantic publication having an identifier corresponding to the identifier comprised by the path of the semantic reference. Correspond means the same. The semantic publication may be identified among each other semantic publication of the determined semantic node (automatically or by a user, e.g., manipulating upon user interaction the semantic publication displayed on the display). The assembling may further comprise pointing the semantic reference of the first part to the semantic publication of the identified semantic node.

In examples, prior to the assembling, the one or more semantic references of the first subpart each point to a respective semantic publication of a third subpart. The third subpart and the second subpart may each belong to a same type of subpart (e.g., having a same function for the product but designed differently). The third subpart and the second may represent alternatives for this type of subpart. The method may further comprise, prior to the assembling, removing (automatically or by a user, e.g., removing upon user interaction the pointing displayed on the display) the pointing of the one or more semantic references each to a respective semantic publication of the third subpart. Removing the pointing may comprise removing the unidirectional arc formed during the pointing. The removing of a formed unidirectional arc may comprise disassembling each second pointing previously discussed (i.e., each pointing from the semantic reference of the first subpart to the semantic publication of the third subpart).

In these examples, the method may further comprise, prior to the assembling of the first subpart with the second subpart, searching the second subpart in the database based on the semantic representation of the third subpart (e.g., by querying a name). The searching may be performed as previously discussed, thereby retrieving a list of subparts having a semantic representation corresponding to the semantic representation of the third subpart. The method may further comprise displaying the retrieved list of subparts (e.g., displaying a 3D representation for each subpart of the list). The method may further comprise selecting one of the subpart from the retrieved list (e.g., by clicking on one of the displayed 3D representation). The subparts stored in the database may result from prior design, which are therefore reuse for the design of a new product.

The method may thus automatically or upon user interaction disassembling the first subpart and the third subpart and, after the disassembling, automatically assembling the first subpart with the second subpart. The method therefore allows efficiently trying different alternatives of subparts for the product to be manufactured. The method therefore allows automatically exploring design alternatives.

In these examples, prior to the assembling, the one or more semantic references of the first subpart (*i*.*e*. those pointed to publication(s) of the second subpart during the assembling) each point to a respective semantic publication of a third subpart, and, after the assembling, these semantic references of the first subpart point to semantic publications of the second subpart. In these examples, the method further comprising, prior to the assembling, removing the pointing of the one or more semantic references each to a respective semantic publication of the third subpart. The third subpart is thus replaced with the second subpart. In other alternatives, prior to the assembling, each semantic publication of the second subpart to which one of the one or more semantic references of the first subpart is pointed to during the assembling is pointed to by a respective semantic reference of a third subpart. In these other alternatives, the method further comprising, prior to the assembling, removing the pointing of each respective semantic reference of the third subpart each to a respective semantic publication of the second subpart. The third subpart is thus replaced with the first subpart.

In examples, the method may further comprises, for each subpart computing a signature of each semantic node of the semantic representation representing the subpart. For example, the signature may concatenate the name of the semantic representation and attributes of the semantic node. The attributes of the semantic node may comprise the identifier of each semantic publication that the semantic node comprises. Alternatively or additionally, the attributes of the semantic node may comprise the path of each semantic reference that the semantic node comprises. The signature may be a 224-bit identifier computed on each semantic representation, and may enable to identify quickly semantic representation with similar content among a set of semantic representations (e.g., stored in a database). The signature allows quickly comparing two semantic representations. The method may compute the signature by creating a character string concatenating some of the data of the semantic representation (name of the semantic description, type, name and path of each semantic publication, publications being sorted by alphabetical order of their name, type and name of each semantic reference, references being sorted by alphabetical order of their name) and by condensation of this character string using the SHA-224 hash function (for example, as described in https://fr.wikipedia.org/wiki/SHA-2 ).

In examples, the first subpart and the second subpart may be stored in a database. The database may further store one or more additional subparts. The one or more additional subparts may comprise other alternatives having the same type as the second subpart. The method may comprise querying in the database based on the signature (e.g., the user may input a signature and the method may search in the database subparts corresponding to the signature, e.g. that are equal or similar to the inputted signature, or that are complementary to the inputted signature). The method may further comprise identifying in the database at least one subpart having a signature that matches with the signature of the provided first subpart. For example, the identifying may comprise determining that, for each of the at least one subpart, one or more semantic references of the first subpart may point to a respective semantic publication of the subpart (e.g., by determining that the path of each of the one or more semantic references may point to a respective semantic publication of the subpart by referencing to the identifier of the semantic publication). The identified at least one subpart may include the second subpart. The method may further comprise selecting the second subpart among the identified at least one subpart. The selection may be performed upon user interaction. For example, the method may comprise displaying the at least one subpart in a graphical user interface and the user may select one of them, e.g., using a pointing device such as a mouse.

It is further provided a computer-implemented method for obtaining a semantic representation representing a subpart (hereinafter referred to as the "obtaining method").

The obtaining method comprises determining one or more semantic nodes. The determining of the one or more semantic nodes may be performed manually. For example, a user may, in a graphical user interface, enter a number of nodes and provide a name for each node. Alternatively, the determining of the one or more semantic nodes may be performed automatically. For example, the determining may comprise detecting end portions of the subpart or connecting portions to be assembled and assigning a respective semantic node to each of the detected end portion or connecting portions of the subpart.

The obtaining method comprises, for each semantic node, defining a respective procedural graph and a respective semantic description of the semantic node. The procedural graph may be defined automatically. For example, the procedural graph may be retrieved from a database or may be automatically extracted from a modeling of the portion of the subpart representing the semantic node (e.g., using a CAD system). The semantic description may comprise at least one semantic publication and/or at least one semantic reference (e.g., automatically determined by the obtaining method based on the procedural graph or manually entered by the user). The path of the at least one semantic reference and/or the identifier of the at least one semantic publication may be automatically determined by the obtaining method or manually entered by the user.

After the determination of the semantic reference (i.e., of semantic nodes and the semantic description), the method may comprise associating the semantic reference to the subpart (i.e., binding the semantic representation to the subpart). The obtaining method may be executed after the design of the subpart.

A three-dimensional modeled object can be represented as a graph wherein nodes are geometrical objects and unidirectional arcs are procedural relationships between these objects.

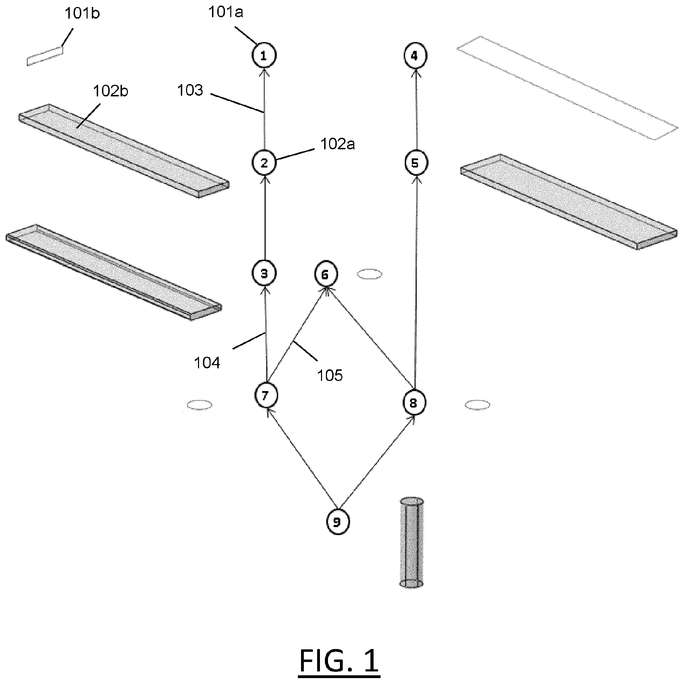

With reference to FIGs. 1 to 17, examples of the method is now discussed.

FIG. 1 shows an example of a procedural graph representing a product. The procedural graph comprises nodes (e.g., ode 101a having the identifier "1" or node 102a having the identifier "2") and unidirectional arcs between these nodes (e.g., the unidirectional arc 103 between nodes 101a and 102a). Each node represent a respective geometrical object. The node 101a represents a profile 101b and the node 102a represents a parallelogram 102b. The unidirectional arcs of the procedural graph represent functions between nodes of the graph. A function takes as input the geometrical object represented by each node pointed by an unidirectional arc associated with the function. A function may be associated with a single unidirectional arc, or with several unidirectional arcs. For example, the unidirectional arc 103 is associated with an extrusion function, which is associated with a single unidirectional arc in this example (the unidirectional arc 103). Examples of function includes wireframe operations (such as Point, Points repetition, Extremum, ExtremumPolar, Line, Axis, Polyline, Plane, Projection, Combine, ReflectLine, Silhouette, Intersection, Parallel Curve, Rolling Offset, 3D Curve Offset, Circle, Corner, Connect Curve, Conic, Spline, Helix, Spiral, Spine, Contour, Isoparametric Curve or Curve from Equations), surfacic operations (such as Extrude, Revolve, Sphere, Cylinder, Offset, Variable Offset, Rough Offset, Mid Surface, Sweep, Adaptive Sweep, Fill Multi-Sections Surface or Blend) or volumic operations (such as Volume Extrude, Volume Revolve, Multi-Sections Volume, Volume Sweep, Thick Surface, Close Surface, Draft, Draft Variable Angle, Shell, Sew Surface, Thickness, Add, Remove, Intersect, Union Trim or Defeaturing). The function takes as input the geometrical object 101b of the node 101a pointed by the unidirectional arc 103. The geometrical object 102b of the node 102a from which the unidirectional arc 103 points is the result of the extrusion of the geometrical object 101b according to a normal direction (the normal direction of the geometrical object 101b in this example). Similarly, the geometrical object of the node "3" is the result of a filleting operation of four edges of the geometrical object of the node "2". The geometrical object of the node "5" is the result of the extrusion of the profile of the node "4" according to a normal direction of the profile "4". The unidirectional arcs 104 and 105 are associated with a same function, which is a projection function. The projection function projects the geometrical object represented by one of the pointed nodes on the geometrical object represented by the other one of the pointed nodes. In this example, the geometrical object of the node "7" is the result of the projection of the profile of the node "6" on the geometrical object of the node "3". Similarly, the geometrical object of the node "8" is the result of the projection of the profile of the node "6" on the geometrical object of the node "5". The geometrical object of the node "9" is the result of the sweep operation using the profile of the node "7" and the profile of the node "8". The sweep operation is a function creating a 3D object between two profiles.

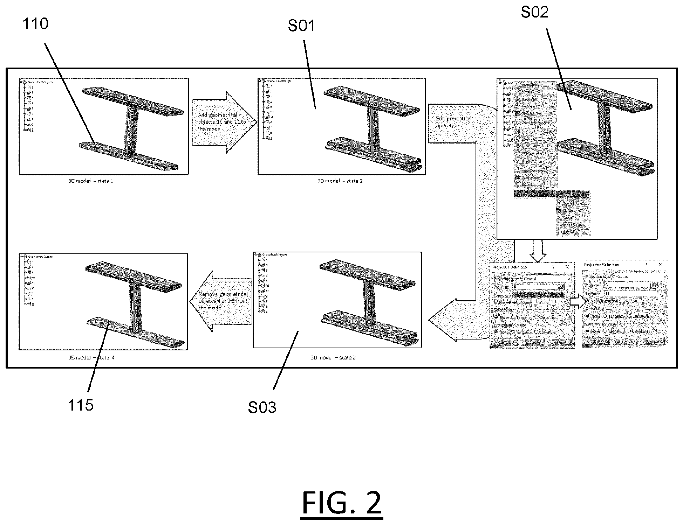

FIG. 2 illustrates an example of a prior art method for replacing a subpart by manipulating manually the underlying procedural graph. The replacement consists in replacing the subpart 110 with another subpart 115. The prior art method comprises adding S01 the another subpart 115 to the 3D modeled object representing the product. The prior art method comprises editing S02 projection operations of the subpart 110, thereby editing in the underlying procedural graph the unidirectional arc pointing to the node corresponding to the subpart 110. The editing S02 comprises removing in the underlying procedural graph the pointing to the subpart 110 and adding in the underlying procedural graph a new pointing to the added another subpart 115. The prior art method comprises removing S03 the subpart 110, thereby obtaining the 3D modeled object having the another subpart 115.

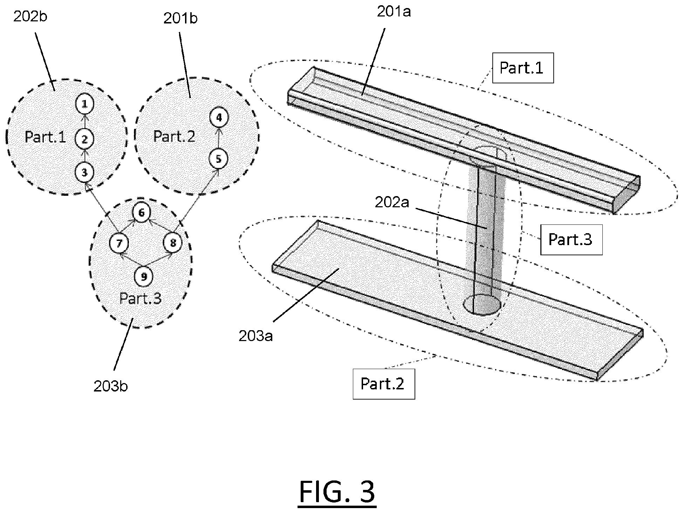

FIG. 3 shows an example of 3D modeled object resulting from the executing of the procedural graph of FIG. 1. The product represented by the procedural graph comprises three subparts ("Part.1", "Part.2" and "Part.3") that are assembled during the manufacturing of the product. Each subpart is associated with a respective portion of the procedural graph. The subpart 201a is associated with the portion 201b of the procedural graph (and the subpart 202a with the portion 202b and the subpart 203a with the portion 203b). The execution of the procedural graph results in the construction of a 3D modeled object representing the product. The constructed 3D modeled object comprises three sub-objects 201a, 202a and 203a representing each of the subparts of the product. A function associated with a unidirectional arc between two portions of the procedural graph (e.g., between 202b and 203b) represents the assembling of the subparts associated with each of the two portions. The executing of the procedural graph comprises a successive execution of the functions of the graph according to the directions of the unidirectional arcs (also referred to as a traversal of the graph).

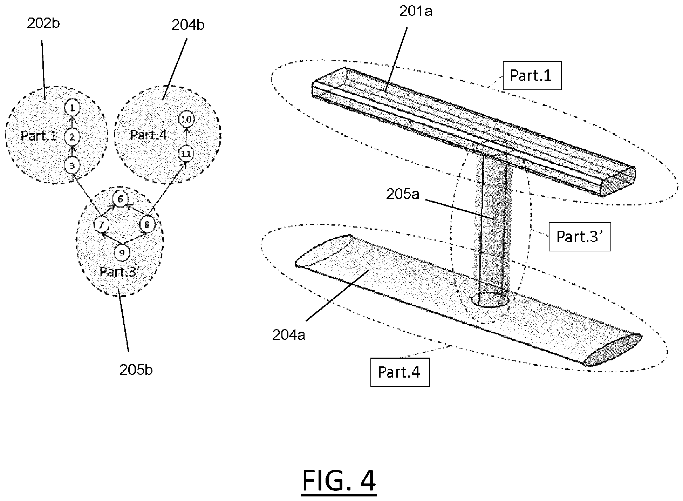

FIG. 4 shows an example of design alternative for the product of FIG. 1. In the product, the subpart "Part.2" has been replaced with a design alternative "Part.4". The product is thus the same between FIG. 1 and FIG. 4, but with another design alternative. The design alternative "Part.4" of FIG. 4 plays the same role than the "Part.2" of FIG. 1. In the procedural graph, the replacing of the subpart "Part.2" with the design alternative "Part.4" comprises the removing of the unidirectional arc between the node "8" and the node "5" of the subpart "Part.2" and the adding of a new unidirectional arc between the node "8" and the node "11" of the "Part.4".

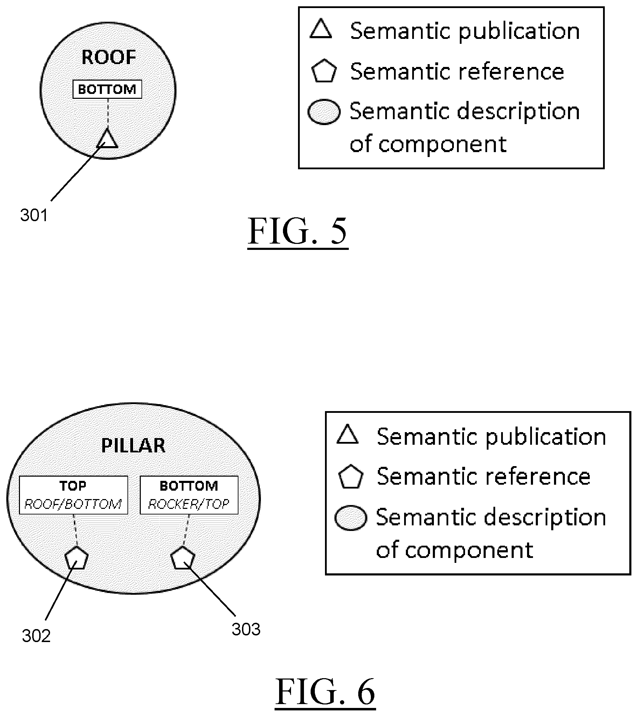

FIGs. 5 and 6 illustrate two examples of semantic node. FIG. 5 illustrates a first semantic node called "ROOF". The first semantic node comprises a semantic description comprising the name of the first semantic node "ROOF" and a semantic publication 301. The semantic publication 301 comprises an identifier "BOTTOM" so as to be pointed to by a semantic reference of another semantic node. FIG. 6 illustrates a second semantic node called "PILLAR". The second semantic node comprises a semantic description comprising the name of the second semantic node "PILLAR" and two semantic references 302 and 303. The semantic reference 302 comprises a path "ROOF/BOTTOM" so as to point to the semantic publication of another semantic node. The path "ROOF/BOTTOM" is a concatenation of the name of a respective semantic node ("ROOF") and the identifier of a respective semantic publication ("BOTTTOM"). The semantic reference 302 may thus point to a semantic publication comprising the identifier "BOTTOM" which is comprised in a semantic node called "ROOF" (e.g., such as the semantic publication 301 of the first semantic node of FIG. 5). The semantic reference 303 comprises a path "ROCKER/TOP" which is a concatenation of the name of a respective semantic node ("ROCKER") and the identifier of a respective semantic publication ("TOP"). The semantic reference 303 may thus point to a semantic publication comprising the identifier "TOP" which is comprised in a semantic node called "ROCKER".

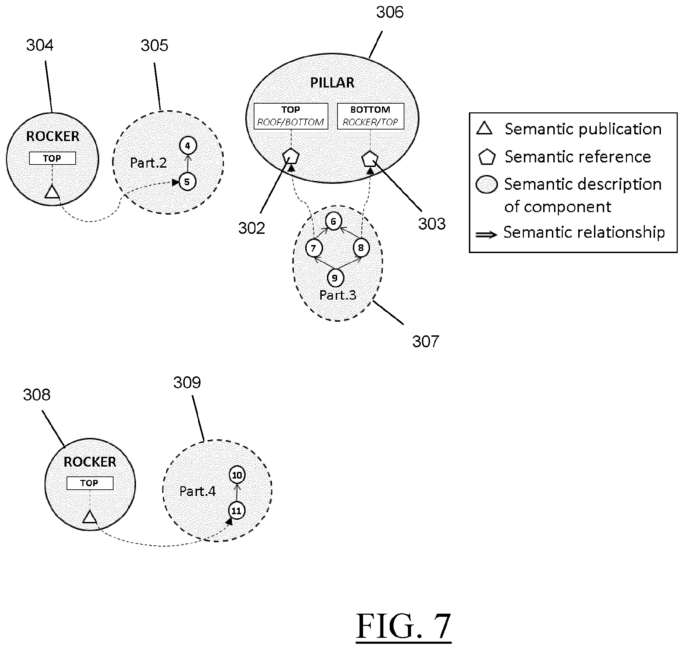

FIG. 7 shows examples of pointing of semantic publication or reference. FIG. 7 shows a first semantic node 304 called "ROCKER". The semantic description of the first semantic node comprises a single publication having as identifier "TOP". The first semantic node comprises the procedural graph 305. The publication "TOP" points to the node "5" of the procedural graph 305. FIG. 7 further shows the second semantic node 306 called "PILLAR" of FIG. 6. The semantic reference 302 is pointed to by the node "7" of the procedural graph 307 and the semantic reference 303 by the node "8". FIG. 7 also shows a third semantic node. The third semantic node comprises the same semantic description as the first semantic node but comprises another semantic graph 309. The publication "TOP" points to the node "11" of the procedural graph 309.

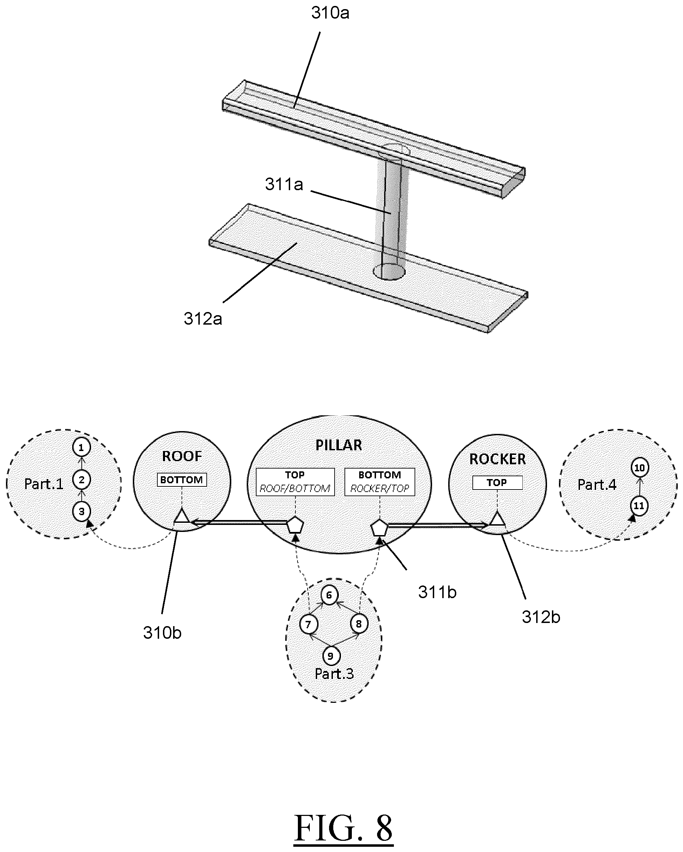

FIG. 8 shows an example of semantic representation of the product of FIG. 1. The product comprises a first subpart 310a called "ROOF", a second subpart 311a called "PILLAR" and a third subpart 312a called ROCKER. The semantic representation comprises, for each subpart a respective semantic node (the node 310b for the "ROOF", the node 311b for the "PILLAR" and the node 312b for the "ROCKER"). The semantic reference "TOP" of the "PILLAR" points to the semantic publication "BOTTOM" of the "ROOF" and the semantic reference "BOTTOM" of the "PILLAR" points to the semantic publication "TOP" of the "ROCKER". The semantic representation is close to the human language and eases the understanding of the way components are linked.

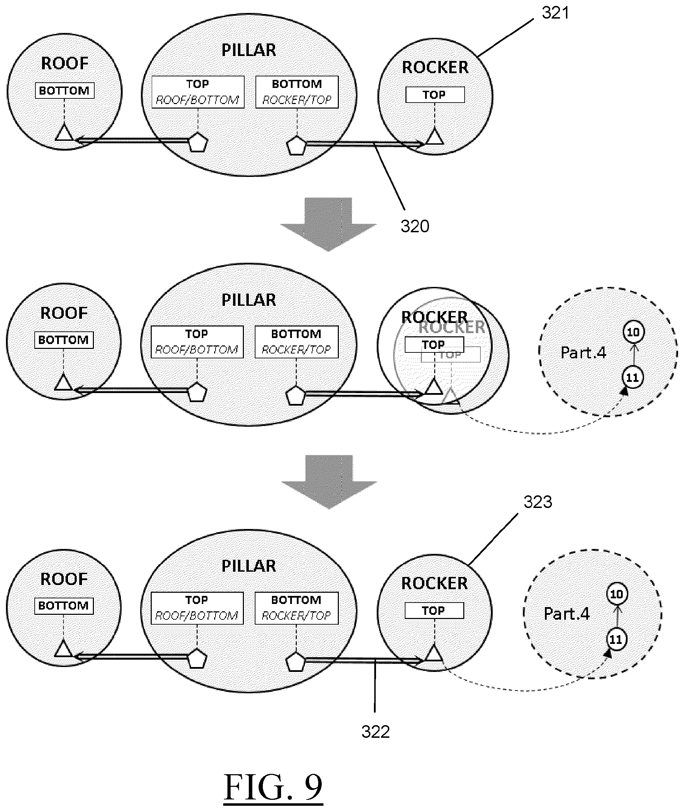

FIG. 9 shows an example of replacing a subpart of a product. In this example, the method replaces the subpart "ROCKER" associated with the semantic node 321. In the semantic representation of the product, the node "ROCKER" 321 comprises a semantic publication "TOP" pointed to 320 by the semantic reference "BOTTOM" of the node "PILLAR". The method comprises removing the pointing 320 to the semantic reference "TOP" of the node 321 and adding a new pointing 322 to the semantic reference "TOP" of the node 323.

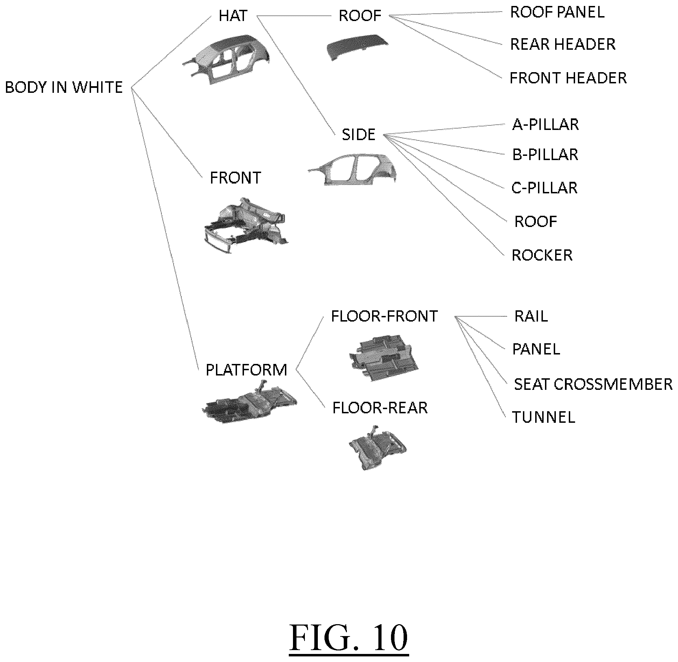

FIG. 10 shows a tree structure illustrating the components of a Body in White and how these components are assembled to each other to ultimately form the full Body in White. As shown on FIG. 10, a Body in White comprises components and components of components each representing a respective part (or a respective assembly of parts) of the automobile. The Body in White comprises a HAT component, a FRONT component and a PLATFORM component. The HAT component comprises a ROOF component and a SIDE component. The ROOF component comprises a ROOF PANEL component, a REAR HEADER component and a FRONT HEADER component. The SIDE component comprises a A-PILLAR component, a B-PILLAR component, a C-PILLAR component, a ROOF component and a ROCKER component. The PLATFORM component comprises a FLOOR-FRONT component and a FLOOR-REAR component. The FLOOR-FRONT component comprises a RAIL component, a PANEL component, a SEAT CROSSMEMBER component and a TUNNEL component.

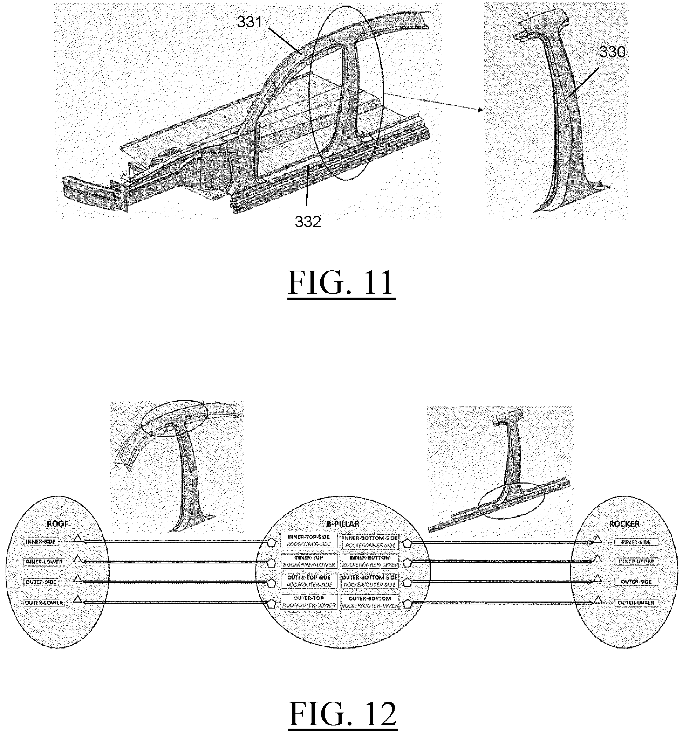

FIG. 11 shows an example of a B-PILLAR component of the Body in White of FIG. 10. The B-PILLAR component 330 is mechanically assembled with a ROOF component 331 and a ROCKER component 332. FIG. 12 shows an example of semantic representation of the B-PILLAR component of FIG. 11. The semantic representation comprises a first semantic node representing the ROOF component 331, a second semantic node representing the B-PILLAR component 330 and a third semantic node representing the ROCKER component 332. The second semantic node comprises eight semantic references, four pointing to a respective semantic publication of the ROOF component and four pointing to a respective semantic publication of the ROCKER.

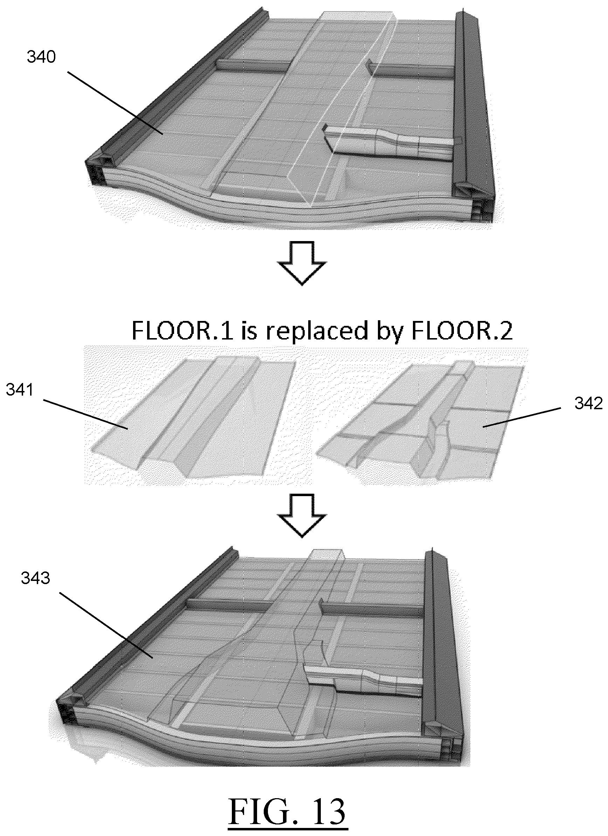

FIG. 13 shows an example of replacement of the FLOOR component of the Body in White of FIG. 10. The FLOOR component comprises two alternatives 341 and 342. The method takes as input the automobile 340 comprises a first alternative 341. The method replaces the first alternative 341 with a second alternative 342. Then, the method outputs the automobile 343 comprising the second alternative 341.

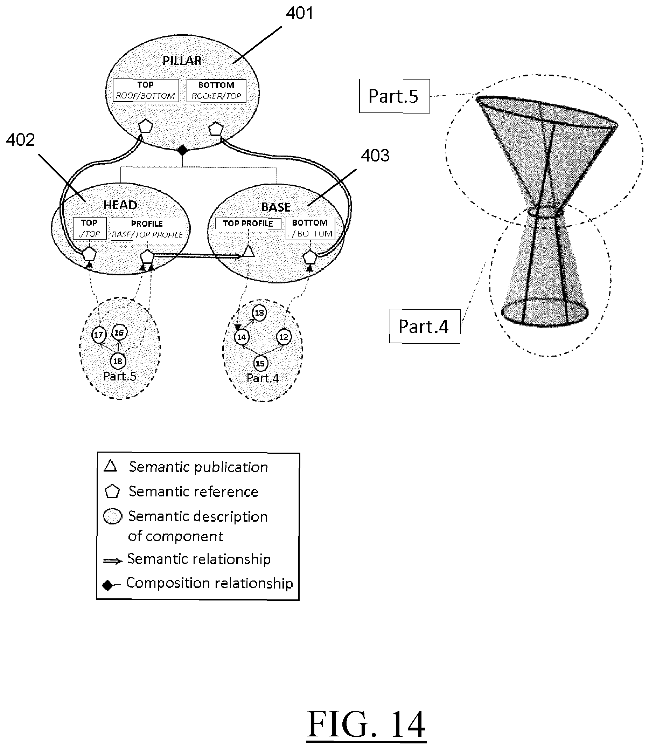

FIG. 14 shows an example of a semantic composition. The semantic composition comprises a first semantic node "HEAD" 402 and a second semantic node "BASE" 403. The semantic reference "BOTTOM" of the semantic node "BASE" is delegated to the semantic composition, which comprises a duplication of the semantic reference. The path "./BOTTOM" of the semantic reference "BOTTOM" is a concatenation of a path to the semantic composition "./" and of the identifier of the semantic reference "BOTTOM" of the semantic composition comprising the name and the identifier of the semantic publication that the semantic reference "BOTTOM" may point. The semantic publication that may be pointed by the semantic reference "BOTTOM" is comprised in a semantic node called "ROCKER" and has the identifier "TOP". The semantic reference is delegated to the semantic composition. The semantic composition is close to the human language and eases the understanding of the way components are linked.

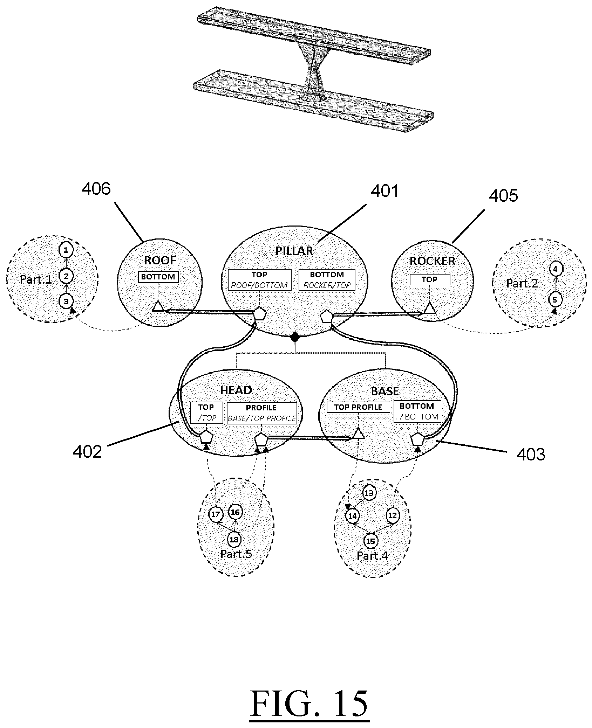

FIG. 15 shows an assembling of the semantic composition of FIG. 13 with two subparts. The assembling comprises pointing the semantic reference "BOTTOM" of the semantic node "BASE" to the semantic publication "TOP" to the semantic publication "TOP" of the "ROCKER". As previously discussed the semantic reference "BOTTOM" is delegated to the semantic composition "PILLAR". The assembling further comprises pointing the semantic reference "TOP" of the semantic node "HEAD" to the semantic publication "BOTTOM" of the "ROOF". The semantic reference "TOP" of the semantic node "HEAD" is also delegated to the semantic composition.

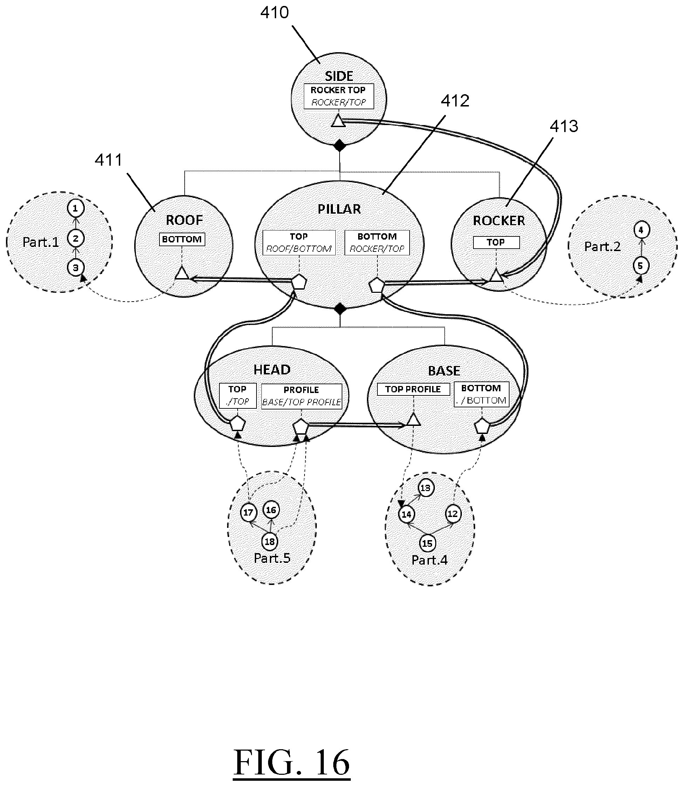

FIG. 16 shows a semantic composition comprising the assembling of FIG. 15. After the assembling as discussed in FIG. 14, the method comprise adding a semantic composition "SIDE" 410 comprising the semantic node "ROOF" 411, the semantic nodes of the semantic composition "PILLAR" 412 and the semantic node "ROCKER" 413. The method may further comprise replacing the subpart "PILLAR" 412 with another subpart "PILLAR" 412 or may further adding the semantic composition "SIDE" 410 to an automotive comprising a semantic representation having a semantic composition called "SIDE" 410 (or replacing the subpart "SIDE"410 in an automotive, i.e., with an alternative for the component "SIDE 410").

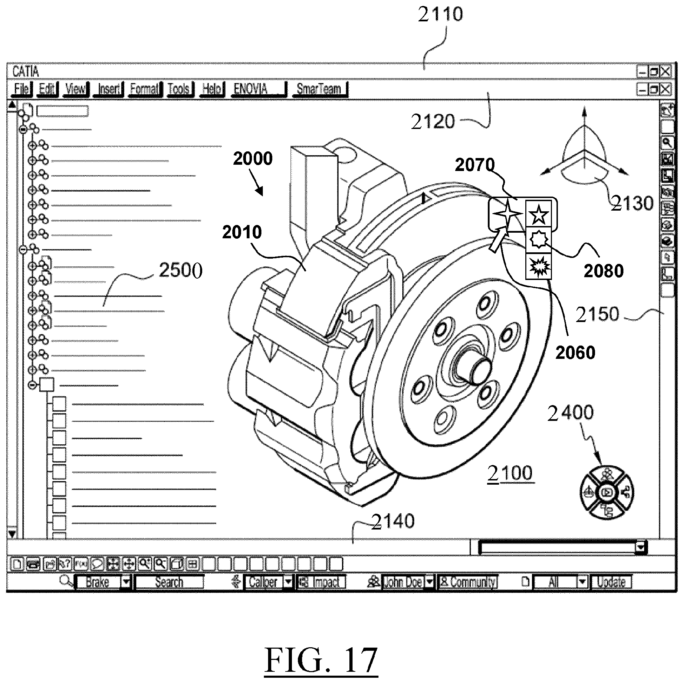

FIG. 17 shows an example of the GUI of the system, wherein the system is a CAD system.

The GUI 2100 may be a typical CAD-like interface, having standard menu bars 2110, 2120, as well as bottom and side toolbars 2140, 2150. Such menu- and toolbars contain a set of user-selectable icons, each icon being associated with one or more operations or functions, as known in the art. Some of these icons are associated with software tools, adapted for editing and/or working on the 3D modeled object 2000 displayed in the GUI 2100. The software tools may be grouped into workbenches. Each workbench comprises a subset of software tools. In particular, one of the workbenches is an edition workbench, suitable for editing geometrical features of the modeled product 2000. In operation, a designer may for example pre-select a part of the object 2000 and then initiate an operation (e.g. change the dimension, color, etc.) or edit geometrical constraints by selecting an appropriate icon. For example, typical CAD operations are the modeling of the punching or the folding of the 3D modeled object displayed on the screen. The GUI may for example display data 2500 related to the displayed product 2000. In the example of the figure, the data 2500, displayed as a "feature tree", and their 3D representation 2000 pertain to a brake assembly including brake caliper and disc. The GUI may further show various types of graphic tools 2130, 2070, 2080 for example for facilitating 3D orientation of the object, for triggering a simulation of an operation of an edited product or render various attributes of the displayed product 2000. A cursor 2060 may be controlled by a haptic device to allow the user to interact with the graphic tools.

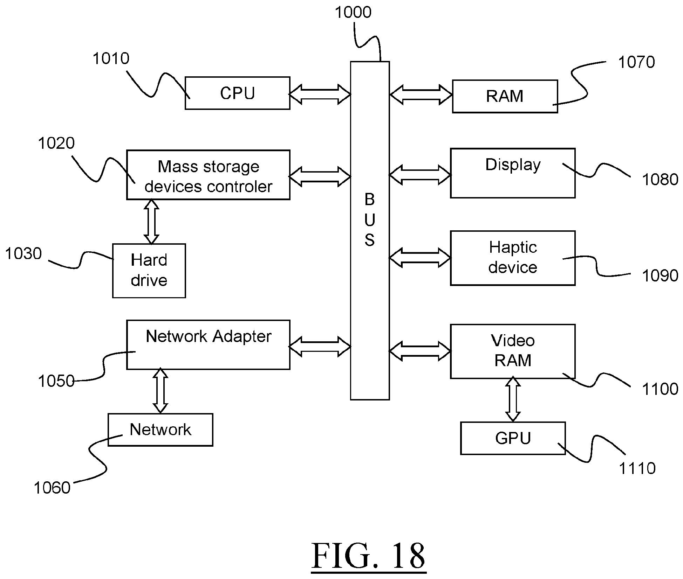

FIG. 18 shows an example of the system, wherein the system is a client computer system, e.g. a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

## Claims

1. A computer-implemented method for designing a product to be manufactured, the method comprising:
- providing a first subpart and a second subpart of the product, each subpart being represented by a semantic representation having one or more semantic nodes, each semantic representation having, for each semantic node of the semantic representation, a respective procedural graph and a respective semantic description of the semantic node, the respective semantic description comprising:
-- at least one semantic publication, each semantic publication pointing to a given node of the procedural graph of the semantic node and comprising an identifier so as to be pointed to by a semantic reference of another semantic node; and/or
-- at least one semantic reference, each semantic reference comprising a path so as to point to a semantic publication of another semantic node by referencing to the identifier of the semantic publication, each semantic reference being pointed to by a node of the procedural graph of the semantic node;
- assembling the first subpart with the second subpart by pointing one or more semantic references of the first subpart each to a respective semantic publication of the second subpart; and
- executing the procedural graphs of the semantic representations of the first and second subparts according to the pointed one or more semantic references, thereby providing a 3D modeled object representing an assembly of the first and second subparts of the product,
wherein each respective semantic description of the semantic node comprises a name of the semantic node and each path comprises a reference to the name of a respective semantic node and to the identifier of a respective semantic publication, and
using the provided 3D modeled object for manufacturing the product.

2. The method of claim 1, wherein the assembling comprises, for each semantic reference of the one or more semantic references:
- identifying the semantic node of the second subpart having a name that corresponds to the name referenced by the path of the semantic reference and comprising a semantic publication having an identifier corresponding to the identifier referenced by the path of the semantic reference; and
- pointing the semantic reference of the first part to the semantic publication of the identified semantic node.

3. The method of claim 1 or 2, wherein:
- prior to the assembling, the one or more semantic references of the first subpart each point to a respective semantic publication of a third subpart, the method further comprising, prior to the assembling:
- removing the pointing of the one or more semantic references each to a respective semantic publication of the third subpart, or
- prior to the assembling, each semantic publication of the second subpart to which one of the one or more semantic references of the first subpart is pointed to during the assembling is pointed to by a respective semantic reference of a third subpart, the method further comprising, prior to the assembling:
- removing the pointing of each respective semantic reference of the third subpart each to a respective semantic publication of the second subpart.

4. The method of any one of claims 1 to 3, the method further comprising, for each subpart:
- computing a signature of each semantic node of the semantic representation representing the subpart, the signature concatenating:
-- the name of the semantic representation; and
-- the identifier of each semantic publication and/or the path of each semantic reference.

5. The method of claim 4, wherein the first subpart and the second subpart are stored in a database, the database further storing one or more additional subparts, the method further comprising:
- identifying in the database at least one subpart having a signature that matches with the signature of the provided first subpart, the identified at least one subpart including the second subpart; and
- selecting the second subpart among the identified at least one subpart.

6. The method of any one of claims 1 to 5, wherein during the executing, each procedural graph pointing to a semantic reference is executed after the executing of the procedural graph pointed by a semantic publication pointed by the semantic reference.

7. The method of any one of claims 1 to 6, wherein each subpart is a component or a component of a component of a Body in White, the Body in White comprising:
- a HAT component comprising:
-- a ROOF component comprising:
--- ROOF PANEL component;
--- REAR HEADER component; or
--- FRONT HEADER component, and
-- a SIDE component comprising:
--- A-PILLAR component;
--- B-PILLAR component;
--- C-PILLAR component;
--- ROOF component; or
--- ROCKER component,
- a FRONT component; and
- a PLATFORM component comprising:
-- a FLOOR-FRONT component comprising:
--- RAIL component;
--- PANEL component;
--- SEAT CROSSMEMBER component; or
--- TUNNEL component; and
-- a FLOOR-REAR component.

8. The method of claim 7, wherein the name of a semantic node is the name of the component corresponding to the semantic node.

9. A computer-implemented method for obtaining a semantic representation representing a subpart, the method comprising:
- determining one or more semantic nodes; and
- for each semantic node, defining a respective procedural graph and a respective semantic description of the semantic node, the semantic description comprising:
-- at least one semantic publication, each semantic publication pointing to a given node of the procedural graph of the semantic node and comprising an identifier so as to be pointed to by a semantic reference of another semantic node; and/or
-- at least one reference, each semantic reference comprising a path so as to point to a semantic publication of another semantic node by referencing to the identifier of the semantic publication, each semantic reference being pointed to by a node of the procedural graph of the semantic node,
wherein the respective semantic description of the semantic node comprises a name of the semantic node and each path comprises a reference to the name of a respective semantic node and to the identifier of a respective semantic publication, and
using the obtained semantic representation for manufacturing a product comprising the subpart represented by the obtained semantic representation.

10. A computer program comprising instructions for performing the method of any of claims 1-8 and/or the method of claim 9.

11. A computer readable storage medium having recorded thereon a computer program of claim 10.

12. A system comprising a processor coupled to a memory, the memory having recorded thereon the computer program of claim 10.

## Patentansprüche

1. Computerimplementiertes Verfahren zum Konstruieren eines herzustellenden Produkts, das Verfahren umfassend:
- Bereitstellen eines ersten Subteils und eines zweiten Subteils des Produkts, wobei jedes Subteil durch eine semantische Darstellung dargestellt wird, die einen oder mehrere semantischen Knoten aufweist, wobei jede semantische Darstellung für jeden semantischen Knoten der semantischen Darstellung einen jeweiligen prozeduralen Graphen und eine jeweilige semantische Beschreibung des semantischen Knotens aufweist, die jeweilige semantische Beschreibung umfassend:
-- mindestens eine semantische Publikation, wobei jede semantische Publikation auf einen bestimmten Knoten des prozeduralen Graphen des semantischen Knotens verweist, und umfassend einen Identifikator, auf den eine semantische Referenz eines anderen semantischen Knotens verweist; und/oder
-- mindestens eine semantische Referenz, wobei jede semantische Referenz einen Pfad umfasst, der auf eine semantische Publikation eines anderen semantischen Knotens verweist, indem er den Identifikator der semantischen Publikation referenziert, wobei durch einen Knoten des prozeduralen Graphen des semantischen Knotens auf jede semantische Referenz verwiesen wird;
- Zusammenfügen des ersten Subteils mit dem zweiten Subteil, indem eine oder mehrere semantische Referenzen des ersten Subteils jeweils auf eine entsprechende semantische Publikation des zweiten Subteils verweisen; und
- Ausführen der prozeduralen Graphen der semantischen Darstellungen des ersten und des zweiten Subteils gemäß der einen oder den mehreren semantischen Referenzen, auf die verwiesen wird, dadurch Bereitstellen eines 3D-modellierten Objekts, das ein Zusammenfügen des ersten und des zweiten Subteils des Produkts darstellt,
wobei jede jeweilige semantische Beschreibung des semantischen Knotens einen Namen des semantischen Knotens umfasst und jeder Pfad eine Referenz zu dem Namen eines jeweiligen semantischen Knotens und zu dem Identifikator einer jeweiligen semantischen Publikation umfasst, und
Verwenden des bereitgestellten 3D-Modells für die Herstellung des Produkts.

2. Verfahren nach Anspruch 1, wobei das Zusammenfügen für jede semantische Referenz der einen oder mehreren semantischen Referenzen Folgendes umfasst:
- Identifizieren des semantischen Knotens des zweiten Subteils mit einem Namen, der dem Namen entspricht, den der Pfad der semantischen Referenz referenziert, und umfassend eine semantische Publikation, die einen Identifikator aufweist, der dem Identifikator entspricht, der durch den Pfad der semantischen Referenz referenziert wird; und
- Verweisen der semantischen Referenz des ersten Teils auf die semantische Publikation des identifizierten semantischen Knotens.

3. Verfahren nach Anspruch 1 oder 2, wobei:
- die eine oder die mehreren semantischen Referenzen des ersten Subteils vor dem Zusammenfügen jeweils auf eine entsprechende semantische Publikation eines dritten Subteils verweisen, das Verfahren vor dem Zusammenfügen ferner umfassend:
- Entfernen des Verweises der einen oder mehreren semantischen Referenzen jeweils auf eine entsprechende semantische Publikation des dritten Subteils, oder
- vor dem Zusammenfügen wird auf jede semantische Publikation des zweiten Subteils, auf die eine von der einen oder den mehreren semantischen Referenzen des ersten Subteils während des Zusammenfügens verweisen, durch eine entsprechende semantische Referenz eines dritten Subteils verwiesen,
das Verfahren ferner umfassend vor dem Zusammenfügen:
- Entfernen des Verweises jeder jeweiligen semantischen Referenz des dritten Subteils auf eine jeweilige semantische Publikation des zweiten Subteils.

4. Verfahren nach einem der Ansprüche 1 bis 3, das Verfahren für jedes Subteil ferner umfassend:
- Berechnen einer Signatur von jedem semantischen Knoten der semantischen Darstellung, die das Subteil darstellt, wobei die Signatur Folgendes verkettet:
-- den Namen der semantischen da Stellung; und
-- den Identifikator jeder semantischen Publikation und/oder den Pfad von jeder semantischen Referenz.

5. Verfahren nach Anspruch 4, wobei das erste Subteil und das zweite Subteil in einer Datenbank gespeichert sind, wobei die Datenbank ferner ein oder mehrere zusätzliche Subteils speichert, das Verfahren ferner umfassend:
- Identifizieren in der Datenbank von mindestens einem Subteil, das eine Signatur aufweist, die mit der Signatur des bereitgestellten ersten Subteils übereinstimmt, wobei das identifizierte mindestens eine Subteil das zweite Subteil beinhaltet; und
- Auswählen des zweiten Subteils aus dem mindestens einen identifizierten Subteil.

6. Verfahren nach einem der Ansprüche 1 bis 5, wobei während der Ausführung jeder prozedurale Graph, der auf eine semantische Referenz verweist, nach der Ausführung des prozeduralen Graphen ausgeführt wird, auf den eine semantische Publikation verweist, auf die die semantische Referenz verweist.

7. Verfahren nach einem der Ansprüche 1 bis 6, wobei jedes Subteil eine Komponente oder eine Komponente einer Komponente einer Rohkarosserie ist, die Rohkarosserie umfassend:
- eine HAT-Komponente, umfassend:
-- eine DACH-Komponente, umfassend:
--- DACHPLATTEN-Komponente;
--- HECKTEIL-Komponente; oder
--- FRONTTEIL-Komponente, und
-- eine SEITEN-Komponente, umfassend:
--- A-SÄULEN-Komponente;
--- B-SÄULEN-Komponente;
--- C-SÄULEN-Komponente;
--- DACH-Komponente; oder
--- SCHWELLER-Komponente,
- eine FRONT-Komponente; und
- eine PLATFORM-Komponente, umfassend:
-- eine VORDERBODEN-Komponente, umfassend:
--- SCHIENEN-Komponente;
--- PLATTEN-Komponente;
--- SITZQUETRÄGER-Komponente; oder
--- TUNNEL-Komponente; und
-- eine HECKBODEN-Komponente.

8. Verfahren nach Anspruch 7, wobei der Name eines semantischen Knotens der Name der Komponente ist, die dem semantischen Knoten entspricht.

9. Computerimplementiertes Verfahren zum Erlangen einer semantischen Darstellung, die ein Subteil repräsentiert, das Verfahren umfassend:
- Bestimmen eines oder mehrerer semantischer Knoten; und
- für jeden semantischen Knoten, Definieren eines jeweiligen prozeduralen Graphen und einer jeweiligen semantischen Beschreibung des semantischen Knotens, die semantische Beschreibung umfassend:
-- mindestens eine semantische Publikation, wobei jede semantische Publikation auf einen bestimmten Knoten des prozeduralen Graphen des semantischen Knotens verweist, und umfassend einen Identifikator, auf den eine semantische Referenz eines anderen semantischen Knotens weist; und/oder
-- mindestens eine Referenz, wobei jede semantische Referenz einen Pfad umfasst, der auf eine semantische Publikation eines anderen semantischen Knotens verweist, indem er den Identifikator der semantischen Publikation referenziert, wobei durch einen Knoten des prozeduralen Graphen des semantischen Knotens auf jede semantische Referenz verwiesen wird,
wobei die jeweilige semantische Beschreibung des semantischen Knotens einen Namen des semantischen Knotens umfasst und jeder Pfad eine Referenz zu dem Namen eines jeweiligen semantischen Knotens und zu dem Identifikator einer jeweiligen semantischen Publikation umfasst, und
Verwenden der erlangten semantischen Darstellung zum Herstellen eines Produkts, umfassend das Subteil, das durch die erlangte semantische da Stellung dargestellt ist.

10. Computerprogramm, umfassend Anweisungen zum Durchführen des Verfahrens nach einem der Ansprüche 1-8 und/oder des Verfahrens nach Anspruch 9.

11. Computerlesbares Speichermedium, auf dem ein Computerprogramm nach Anspruch 10 aufgezeichnet ist.

12. System, umfassend einen Prozessor, der mit einem Speicher gekoppelt ist, wobei auf dem Speicher das Computerprogramm nach Anspruch 10 aufgezeichnet ist.

## Revendications

1. Procédé, mis en œuvre par ordinateur, de conception d'un produit à fabriquer, le procédé comprenant le fait de :
- fournir une première sous-pièce et une deuxième sous-pièce du produit, chaque sous-pièce étant représentée par une représentation sémantique ayant un ou plusieurs nœuds sémantiques, chaque représentation sémantique ayant, pour chaque nœud sémantique de la représentation sémantique, un graphe procédural respectif et une description sémantique respective du nœud sémantique, la description sémantique respective comprenant :
-- au moins une publication sémantique, chaque publication sémantique pointant vers un nœud donné du graphe procédural du nœud sémantique, et comprenant un identifiant de manière à être pointée par une référence sémantique d'un autre nœud sémantique ; et/ou
-- au moins une référence sémantique, chaque référence sémantique comprenant un chemin de manière à pointer vers une publication sémantique d'un autre nœud sémantique en faisant référence à l'identifiant de la publication sémantique, chaque référence sémantique étant pointée par un nœud du graphe procédural du nœud sémantique ;
- assembler la première sous-pièce avec la deuxième sous-pièce en pointant chacune d'une ou plusieurs références sémantiques de la première sous-pièce vers une publication sémantique respective de la deuxième sous-pièce ; et
- exécuter les graphes procéduraux des représentations sémantiques des première et deuxième sous-pièces selon la ou les références sémantiques pointées, ce qui permet de fournir un objet modélisé en 3D représentant un assemblage des première et deuxième sous-pièces du produit,
dans lequel chaque description sémantique respective du nœud sémantique comprend un nom du nœud sémantique et chaque chemin comprend une référence au nom d'un nœud sémantique respectif et à l'identifiant d'une publication sémantique respective, et
- utiliser l'objet modélisé en 3D fourni pour fabriquer le produit.

2. Procédé selon la revendication 1, dans lequel l'assemblage comprend, pour chaque référence sémantique de la ou des références sémantiques, le fait de :
- identifier le nœud sémantique de la deuxième sous-pièce dont un nom correspond au nom référencé par le chemin de la référence sémantique et qui comprend une publication sémantique dont un identifiant correspond à l'identifiant référencé par le chemin de la référence sémantique ; et
- pointer la référence sémantique de la première pièce vers la publication sémantique du nœud sémantique identifié.

3. Procédé selon la revendication 1 ou 2, dans lequel :
- avant l'assemblage, la ou les références sémantiques de la première sous-pièce pointent chacune vers une publication sémantique respective d'une troisième sous-pièce, le procédé comprenant en outre, avant l'assemblage, le fait de :
- supprimer le pointage de chacune de la ou des références sémantiques vers une publication sémantique respective de la troisième sous-pièce, ou
- avant l'assemblage, chaque publication sémantique de la deuxième sous-pièce vers laquelle l'une de la ou des références sémantiques de la première sous-pièce est pointée pendant l'assemblage est pointée par une référence sémantique respective d'une troisième sous-pièce, le procédé comprenant en outre, avant l'assemblage, le fait de :
- supprimer le pointage de chaque référence sémantique respective de la troisième sous-pièce vers une publication sémantique respective de la deuxième sous-pièce.

4. Procédé selon l'une quelconque des revendications 1 à 3, le procédé comprenant en outre, pour chaque sous-pièce, le fait de :
- calculer une signature de chaque nœud sémantique de la représentation sémantique représentant la sous-pièce, la signature concaténant :
-- le nom de la représentation sémantique ; et
-- l'identifiant de chaque publication sémantique et/ou le chemin de chaque référence sémantique.

5. Procédé selon la revendication 4, dans lequel la première sous-pièce et la deuxième sous-pièce sont stockées dans une base de données, la base de données stockant en outre une ou plusieurs sous-pièces supplémentaires, le procédé comprenant en outre le fait de :
- identifier, dans la base de données, au moins une sous-pièce dont la signature correspond à la signature de la première sous-pièce fournie, l'au moins une sous-pièce identifiée comprenant la deuxième sous-pièce ; et
- sélectionner la deuxième sous-pièce parmi l'au moins une sous-pièce identifiée.

6. Procédé selon l'une quelconque des revendications 1 à 5, dans lequel, pendant l'exécution, chaque graphe procédural pointant vers une référence sémantique est exécuté après l'exécution du graphe procédural pointé par une publication sémantique pointée par la référence sémantique.

7. Procédé selon l'une quelconque des revendications 1 à 6, dans lequel chaque sous-pièce est un composant ou un composant d'un composant d'une caisse en blanc, la caisse en blanc comprenant :
- un composant COIFFE comprenant :
-- un composant TOIT comprenant :
--- un composant PANNEAU DE TOIT ;
--- un composant CALANDRE ARRIÈRE ; ou
--- un composant CALANDRE AVANT, et
-- un composant PARTIE LATÉRALE comprenant :
--- un composant MONTANT A ;
--- un composant MONTANT B ;
--- un composant MONTANT C ;
--- un composant TOIT ; ou
--- un composant BAS DE CAISSE,
- un composant PARTIE AVANT ; et
- un composant PLATEFORME comprenant :
-- un composant PARTIE AVANT DE PLANCHER comprenant :
--- un composant LONGERON ;
--- un composant PANNEAU ;
--- un composant TRAVERSE DE SIÈGE ; ou
--- un composant TUNNEL ; et
-- un composant PARTIE ARRIÈRE DE PLANCHER.

8. Procédé selon la revendication 7, dans lequel le nom d'un nœud sémantique est le nom du composant correspondant au nœud sémantique.

9. Procédé, mis en œuvre par ordinateur, d'obtention d'une représentation sémantique représentant une sous-pièce, le procédé comprenant le fait de :
- déterminer un ou plusieurs nœuds sémantiques ; et
- pour chaque nœud sémantique, définir un graphe procédural respectif et une description sémantique respective du nœud sémantique, la description sémantique comprenant :
-- au moins une publication sémantique, chaque publication sémantique pointant vers un nœud donné du graphe procédural du nœud sémantique et comprenant un identifiant de manière à être pointée par une référence sémantique d'un autre nœud sémantique ; et/ou
**--** au moins une référence, chaque référence sémantique comprenant un chemin de manière à pointer vers une publication sémantique d'un autre nœud sémantique en faisant référence à l'identifiant de la publication sémantique, chaque référence sémantique étant pointée par un nœud du graphe procédural du nœud sémantique,
dans lequel la description sémantique respective du nœud sémantique comprend un nom du nœud sémantique et chaque chemin comprend une référence au nom d'un nœud sémantique respectif et à l'identifiant d'une publication sémantique respective, et
- utiliser la représentation sémantique obtenue pour fabriquer un produit comprenant la sous-pièce représentée par la représentation sémantique obtenue.

10. Programme informatique comprenant des instructions pour mettre en œuvre le procédé selon l'une quelconque des revendications 1 à 8 et/ou le procédé selon la revendication 9.

11. Support de stockage lisible par ordinateur sur lequel est enregistré le programme informatique selon la revendication 10.

12. Système comprenant un processeur couplé à une mémoire, sur laquelle mémoire est enregistré le programme informatique selon la revendication 10.
